# EUROPEAN PATENT SPECIFICATION

(11) **EP 2 978 012 B1**
(45) Date of publication and mention of the grant of the patent: **07.08.2019**
(21) Application number: 13840128.6
(22) Date of filing: 20.06.2013
(51) Int. Cl.: H01L 29/66, H01L 29/417, H01L 29/45, H01L 29/786

(54) **THIN-FILM TRANSISTOR AND PREPARATION METHOD THEREFOR, ARRAY SUBSTRATE AND DISPLAY DEVICE**
DÜNNSCHICHTTRANSISTOR UND HERSTELLUNGSVERFAHREN DAFÜR, ARRAYSUBSTRAT UND ANZEIGEVORRICHTUNG
TRANSISTOR À COUCHE MINCE ET SON PROCÉDÉ DE PRÉPARATION, SUBSTRAT DE MATRICE ET DISPOSITIF D'AFFICHAGE

(30) Priority: 20.03.2013 CN 201310090696
(43) Date of publication of application: 27.01.2016
(73) Proprietor: BOE Technology Group Co., Ltd., Beijing 100015 (CN)
(72) Inventor: CHEN, Haijing, Beijing 100176 (CN); WANG, Dongfang, Beijing 100176 (CN); JIANG, Chunsheng, Beijing 100176 (CN)
(74) Representative: Brötz, Helmut
(86) International application number: PCT/CN2013/077590
(87) International publication number: WO 2014/146363

(56) References cited:
- WO-A1-2006/094231
- WO-A1-2012/097564
- CN-A- 102 544 104
- CN-A- 102 636 927
- CN-A- 103 000 531
- US-A- 5 658 806
- US-A1- 2006 038 242
- US-A1- 2008 203 501
- US-A1- 2008 230 835
- US-A1- 2009 057 668
- US-A1- 2012 302 003

## Description

### TECHNICAL FIELD

Embodiments of the present invention relate to a thin-film transistor (TFT), a preparation method thereof, an array substrate and a display device.

### BACKGROUND

A thin film transistor (TFT) is a thin-film semiconductor device and widely applied in the fields such as display technology (for instance, liquid crystal display technology and organic light-emitting diode display technology) and integrated circuit (IC) technology.

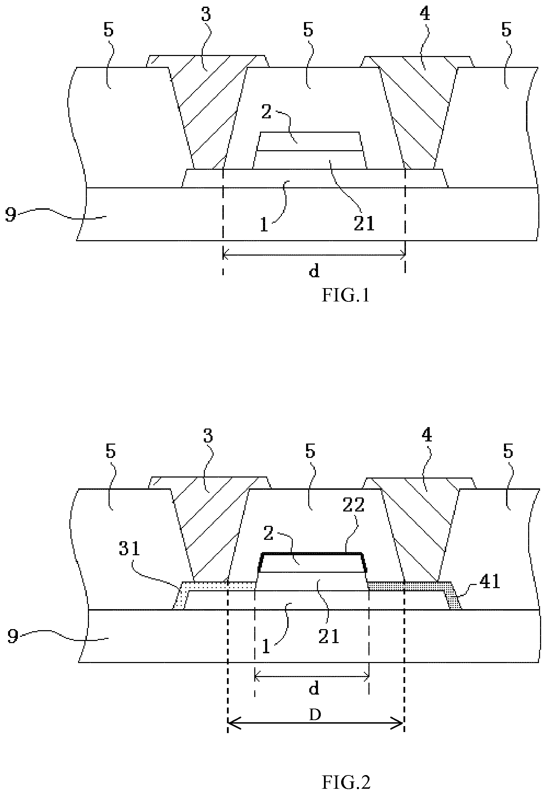

The structure of a top-gate type TFT is as illustrated in FIG. 1. A semiconductor layer (active layer) 1 is disposed on a substrate 9; a gate insulating layer 21 and a gate electrode 2 are disposed on a central portion of the semiconductor layer 1 in sequence; the semiconductor layer 1, the gate electrode 2 and the gate insulating layer 21 are entirely covered by a protection layer 5; and the semiconductor layer 1 on both sides of the gate insulating layer 21 is connected with both a source electrode 3 and a drain electrode 4 via through holes in the protection layer 5. When the TFT is conducted, a portion of the semiconductor layer 1 disposed between the source electrode 3 and the drain electrode 4 is configured to conduct electricity, namely a "conducting channel" is established.
US2006038242A1 discloses a transistor structure employing semiconductive metal oxide as the transistor conductive channel; US2012302003A1 discloses a method of fabricating MOTFTs on transparent substrates; WO2012097564A1 discloses a manufacturing method of self-aligned metal oxide film transistor; US2008203501A1 discloses a semiconductor device with higher reliability and a manufacturing method thereof are provided; US2008230835A1 discloses an element structure of a semiconductor device for having a sufficient contact area between an electrode in contact with a source region or a drain region and the source region or the drain region.

### SUMMARY

The present invention provides a method for preparing a TFT according to the independent claim. Embodiments of the invention are defined in the dependent claims.

In one example, the source conductive layer, the drain conductive layer and the gate insulating layer are all formed on the semiconductor layer; the gate electrode is formed on the gate insulating layer; the TFT further comprises: a protection layer covering the semiconductor layer, the source conductive layer, the drain conductive layer, the gate electrode and the gate insulating layer; and the source electrode and the drain electrode are respectively connected with the source conductive layer and the drain conductive layer via through holes in the protection layer.

In one example, a portion on the upper surface of the semiconductor layer, not covered by the gate insulating layer, is divided into a source region and a drain region, which are independent of each other, by the gate insulating layer; and the source region and the drain region are respectively covered by the source conductive layer and the drain conductive layer.

In one example, the semiconductor layer is a metal oxide semiconductor layer; and the source conductive layer and the drain conductive layer are formed by a chemical plating process.

In one example, the semiconductor layer is selected from the group consisting of a metal oxide semiconductor layer.

In one example, the source conductive layer and the drain conductive layer are made of at least one metal selected from the group consisting of molybdenum, copper, aluminum and tungsten.

In one example, the source conductive layer is composed of at least two mutually overlapped sub-source conductive layers; and/or the drain conductive layer is composed of at least two mutually overlapped sub-drain conductive layers.

In one example, the source conductive layer and the drain conductive layer are made of at least one metal selected from the group consisting of molybdenum, copper, aluminum and tungsten.

In one example, the source conductive layer is composed of at least two mutually overlapped sub-source conductive layers; and/or the drain conductive layer is composed of at least two mutually overlapped sub-drain conductive layers.
provides a display device, which comprises the aforesaid array substrate.

### BRIEF DESCRIPTION OF THE DRAWINGS

In order to clearly illustrate the technical solutions of the embodiments of the invention, the drawings of the embodiments will be briefly described in the following; it is obvious that the described drawings are only related to some embodiments of the invention and thus are not limitative of the invention.
FIG. 1 is a schematic structural sectional view of a cross-section of the traditional TFT running through a source electrode and a drain electrode;
FIG. 2 is a schematic structural sectional view of a cross-section of a TFT provided by a second embodiment of the present invention running through a source electrode and a drain electrode;
FIG. 3 is a schematic structural top view of the TFT provided by the second embodiment of the present invention before a conductive layer is formed in the preparation process;
FIG. 4 is a schematic structural sectional view of the TFT as illustrated in FIG.
   3 along the AA' line;
FIG. 5 is a schematic structural top view of the TFT provided by the second embodiment of the present invention after the conductive layer is formed in the preparation process;
FIG. 6 is a schematic structural sectional view of the TFT as illustrated in FIG. 5 along the BB' line; and
FIG. 7 is a schematic structural sectional view of another TFT provided by the second embodiment of the present invention.

### Reference numerals:

1: Semiconductor layer; 2: Gate electrode; 21: Gate insulating layer; 22: Metal layer; 3: Source electrode; 31: source conductive layer; 4: Drain electrode; 41: Drain conductive layer; 5: Protection layer; 9: Substrate; d: Length of semiconductor region for electrical conduction.

### DETAILED DESCRIPTION

For more clear understanding of the objectives, technical proposals and advantages of the embodiments of the present invention, clear and complete description will be given below to the technical proposals of the embodiments of the present invention with reference to the accompanying drawings of the embodiments of the present invention. It will be obvious to those skilled in the art that the preferred embodiments are only partial embodiments of the present invention but not all the embodiments. All the other embodiments obtained by those skilled in the art without creative efforts on the basis of the embodiments of the present invention illustrated shall fall within the scope of protection of the present invention.

Unless otherwise defined, the technical terms or scientific terms used herein have normal meanings understood by those skilled in the art. The words "first", "second" and the like used in the description and the claims of the patent application of the present invention do not indicate the sequence, the number or the importance but are only used for distinguishing different components. Similarly, the words "a", "an", "the" and the like also do not indicate the number but only indicate at least one. The word "comprise", "include" or the like only indicates that an element or a component before the word contains elements or components listed after the word and equivalents thereof, not excluding other elements or components. The words "connection", "connected" and the like are not limited to physical or mechanical connection but may include electrical connection, either directly or indirectly. The words "on", "under", "left", "right" and the like only indicate the relative position relationship which is correspondingly changed when the absolute position of a described object is changed.

As for the TFT as illustrated in FIG. 1, the inventors found in research that the TFT at least has the following problems: in order to prevent a protection layer 3 between a gate electrode 2 and a source electrode 3 and a drain electrode 4 from breakdown, a large distance must be formed between the source electrode 3 and the drain electrode 4 (namely two through holes). As the source electrode 3 and the drain electrode 4 are electrically conducted through the semiconductor layer 1 which has limited electric conductivity, when the length d of the semiconductor region for electrical conduction is larger, the on-state current of the TFT is lower and the electric conductivity is poorer, and hence the distance between the source electrode 3 and the drain electrode 4 (or the minimum distance between contact portions of the source electrode 3 and the drain electrode 4 with the semiconductor layer 1) must be as small as possible. Meanwhile, the shapes of through holes tend to vary in the forming process. For instance, originally designed square holes can become round holes (particularly for small-size through holes) during an exposure process. The shapes of the through holes have a certain impact on the length d of the semiconductor region for electrical conduction, and hence the length d may be unstable, and consequently the stability of the performances of the TFT may be affected.

### Embodiment 1

The embodiment provides a TFT, which comprises a source electrode, a drain electrode, a semiconductor layer, a gate electrode and a gate insulating layer.

The TFT further comprises: a source conductive layer and a drain conductive layer which are disposed on the surface of the semiconductor layer and spaced from each other; the source conductive layer is connected with the source electrode; the drain conductive layer is connected with the drain electrode; and the minimum distance between the source conductive layer and the drain conductive layer is less than the minimum distance between the source electrode and the drain electrode.

The TFT provided by the embodiment is provided with the source conductive layer and the drain conductive layer, and the current on the source electrode and the drain electrode can be respectively conducted to the source conductive layer and the drain conductive layer. Therefore, the length of the semiconductor region for electrical conduction is determined by the minimum distance between the two conductive layers and not determined by the distance between the source electrode and the drain electrode (or the distance between the through holes). In this case, as long as the position and the shape of the two conductive layers are determined, no matter where the source electrode and the drain electrode are positioned and what the shape of the through holes is, the length of the semiconductor region for electrical conduction cannot change. Therefore, the TFT not only can avoid the breakdown problem but also can ensure large and stable on-state current.

### Embodiment 2

The embodiment provides a TFT. As illustrated in FIGs. 2 to 7, the TFT comprises a source electrode 3, a drain electrode 4, a semiconductor layer 1, a gate electrode 2, a gate insulating layer 21, a source conductive layer 31 and a drain conductive layer 41. The source conductive layer 31 and the drain conductive layer 41 are disposed on the surface of the semiconductor layer 1, namely both the two conductive layers 31 and 41 make contact with the surface of the semiconductor layer 1; and the two conductive layers 31 and 41 are spaced from each other, namely the two conductive layers 31 and 41 do not contact each other. The minimum distance "d" between the source conductive layer 31 and the drain conductive layer 41 is less than the minimum distance "D" between the source electrode 3 and the drain electrode 4.

In a conventional structure of the TFT as illustrated in FIG. 1, the gate electrode 2 and the semiconductor layer 1 are spaced from each other by the gate insulating layer 21, but the source electrode 3 and the drain electrode 4 are respectively connected with the semiconductor layer 1 on both sides of the gate insulating layer 21. The TFT is different from the conventional TFT in that: in the embodiment, the source electrode 3 and the drain electrode 4 are respectively connected with the semiconductor layer 1 on both sides of the gate insulating layer 21 through the source conductive layer 31 and the drain conductive layer 41. Therefore, in this case, the source conductive layer 31 and the drain conductive layer 41 should not make contact with the gate electrode 2 as well.

In accordance with different positions of the gate electrode 2 and the gate insulating layer 21, the TFT includes top-gate type TFT (the gate electrode 2 is disposed on the semiconductor layer 1 and farther away from a substrate 9 than the semiconductor layer 1) and bottom-gate type TFT (the gate electrode 2 is disposed between the semiconductor layer 1 and the substrate 9).

Preferably, the TFT provided by the embodiment is a top-gate type TFT. As illustrated in FIG. 2, the semiconductor layer 1 of the TFT is disposed on the substrate 9; the gate insulating layer 21 is disposed on a central portion of the semiconductor layer 1; the gate electrode 2 is disposed on the gate insulating layer 21; and the source conductive layer 31 and the drain conductive layer 41 are respectively disposed on the surface of the semiconductor layer 1 on both sides of the gate insulating layer 21. Meanwhile, the semiconductor layer 1, the gate electrode 2, the gate insulating layer 21, the source conductive layer 31, the drain conductive layer 41 and the like are all covered by a protection layer 5; and the source electrode 3 and the drain electrode 4 are respectively connected with the source conductive layer 31 and the drain conductive layer 41 via through holes in the protection layer 5.

As for a top-gate type TFT, as the source electrode 3, the drain electrode 4 and the gate electrode 2 of the TFT are all disposed on the top of the semiconductor layer 1, the problem of breakdown among the source electrode 3, the drain electrode 4 and the gate electrode 2 will occur more easily. But the embodiment can reduce or avoid the problem.

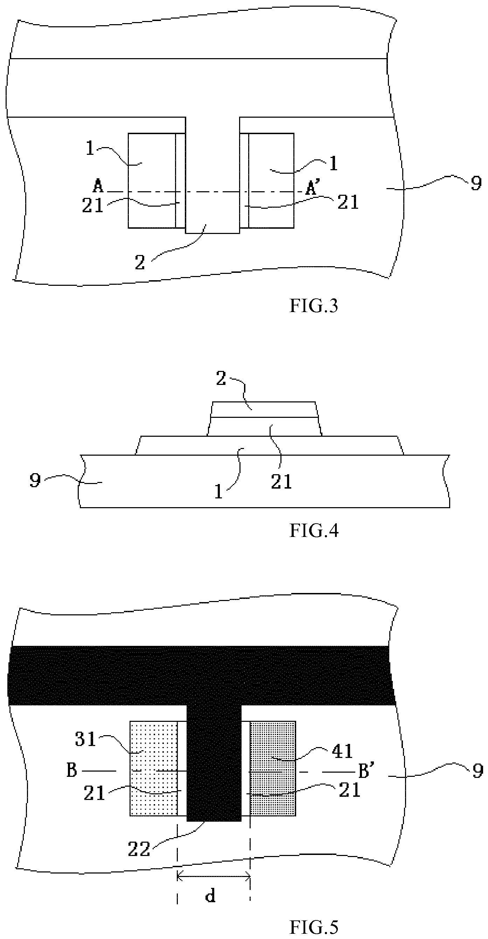

Moreover, preferably, as illustrated in FIG. 3, a portion on the upper surface of the semiconductor layer 1, not covered by the gate insulating layer 21, is divided into a source region (a region on the left of the gate insulating layer 21) and a drain region (a region on the right of the gate insulating layer 21), which are independent of each other, by the gate insulating layer 21. As illustrated in FIG. 5, the source region and the drain region are respectively covered by the source conductive layer 31 and the drain conductive layer 41.

That is to say, the source conductive layer 31 and the drain conductive layer 41 respectively fully cover exposed surfaces of the semiconductor layer 1 and are respectively adjacent to both sides of the gate insulating layer 21. By adoption of the means, the length d of the semiconductor region for electrical conduction can be minimized, and meanwhile the source conductive layer 31 and the drain conductive layer 41 are conducive to be prepared by the chemical plating process.

Preferably, for instance, the source conductive layer 31 and the drain conductive layer 41 are made of at least one metal selected from molybdenum, copper, aluminum and tungsten, for instance, are made of an alloy formed by one or more from the metals.

The metal/alloy materials are commonly used conductive metals in the semiconductor field and have no adverse effect on the performances of semiconductor devices. Of course, other types of conductive materials are also applicable.

Preferably, for instance, the source conductive layer 31 is composed of at least two mutually overlapped sub-source conductive layers; or the drain conductive layer 41 is also composed of at least two mutually overlapped sub-drain conductive layers.

That is to say, at least one between the source conductive layer 31 and the drain conductive layer 41 is composed of a plurality of overlapped layers, and each layer may be made of a same or different material. By adoption of the multi-layer structure, the performances of the source conductive layer 31 and the drain conductive layer 41 can be better adjusted. For instance, the source conductive layer 31 and the drain conductive layer 41 not only are tightly combined with the semiconductor layer but also have good electrical conductivity.

Preferably, for instance, the semiconductor layer 1 is a metal oxide semiconductor layer, namely the TFT is a metal oxide TFT.

The metal oxide TFT is preferable due to the advantages of high carrier mobility, simple preparation process, good film uniformity, low cost and the like. Of course, other material such as amorphous (a-Si) semiconductor, polysilicon (p-Si) semiconductor or organic semiconductor is possibly used as the semiconductor layer 1.

Meanwhile, preferably, when the semiconductor layer 1 is a metal oxide semiconductor layer, the source conductive layer 31 and the drain conductive layer 41 may be prepared by the chemical plating process.

Of course, it should be understood that the TFT of the embodiment is not limited to the top-gate type structure and other types of TFT are also applicable.

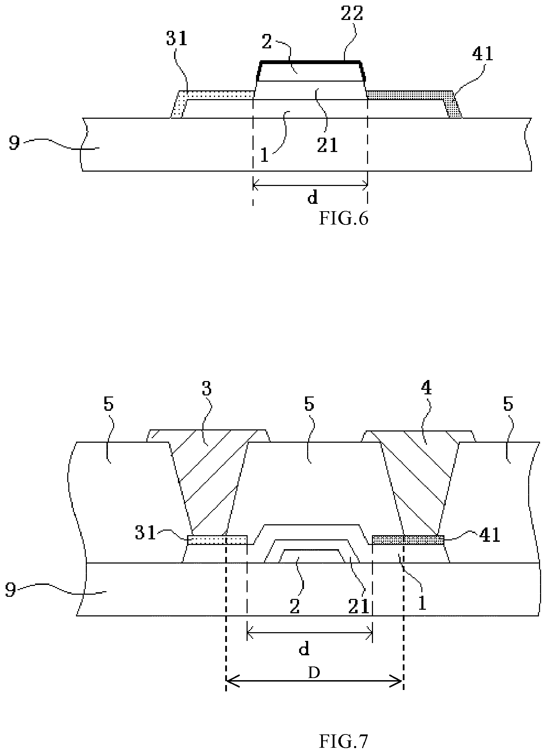

For instance, as illustrated in FIG. 7, in the TFT of another embodiment, the gate electrode 2 and the gate insulating layer 21 are disposed between the semiconductor layer 1 and the substrate 9 (namely the TFT adopts a bottom-gate type structure); and meanwhile, the TFT may further comprise other structures according to specific requirements. For instance, a buffer layer may be disposed on the substrate 9, and the semiconductor layer 1 may further include various doped regions configured to improve the performances thereof. As the TFT has various specific forms, no further description will be given here. As long as the source electrode 3 and the drain electrode 4 are respectively connected with the semiconductor layer 1 through the source conductive layer 31 and the drain conductive layer 41, the TFT should fall within the protection scope of the present invention.

The method for preparing the TFT of the embodiment may comprise the following steps S01 to S06.

S01: forming a pattern of the semiconductor layer 1 on the substrate 9 by a patterning process.

The patterning process is, for instance, photolithography process which usually includes the steps such as layer deposition, photoresist coating, exposure, development, etching, photoresist removing.

S02: depositing a gate insulating layer film on the substrate obtained after the above step is completed.

S03: depositing a gate metal film on the substrate obtained after the above step is completed, forming patterns of the gate insulating layer 21 and the gate electrode 2 by a patterning process, and obtaining the structures as illustrated in FIGs. 3 and 4.

S04: forming the source conductive layer 31 and the drain conductive layer 41, and obtaining the structures as illustrated in FIGs. 5 and 6.

For instance, as for the top-gate type TFT as illustrated in FIG. 2, if the semiconductor layer 1 of the TFT is a metal oxide semiconductor layer, the source conductive layer 31 and the drain conductive layer 41 of the TFT may be formed by a chemical plating process.

The chemical plating process has the advantages of simplicity and low costs. Moreover, due to the technical characteristics, films can only be formed on metals or metal oxides. As for the top-gate type TFT, the substrate 9 of the TFT is usually made of a glass material and the gate insulating layer 21 is usually made of a material such as silicon nitride, so that the source conductive layer 31 and the drain conductive layer 41 can be directly formed on the surface of the semiconductor layer 1 on both sides of the gate insulating layer 21 but a conductive layer cannot be formed on the gate insulating layer 21 and the substrate 9. Therefore, the TFT having the minimum length d of the semiconductor region for electrical conduction as illustrated in FIGs. 5 and 6 can be directly prepared.

Of course, as the gate electrode 2 is usually made of a metal material, a metal layer 22 may further be formed on the gate electrode 2, but the layer has no affect on the performances of the gate electrode 2.

Description will be given below by taking the case that a molybdenum conductive layer is formed by the chemical plating process as an example. At the temperature between the room temperature and 100 centigrade, a molybdenum chemical plating solution is coated on the substrate 9 having the structure as illustrated in FIGs. 3 and 4; the structures as illustrated in FIGs. 5 and 6 can be obtained after the complete reaction of the molybdenum chemical plating solution; and the processes of cleaning and drying and subsequent steps are carried out.

For instance, the composition for the molybdenum chemical plating solution may include: 0.1-0.3mol/L molybdenum sulfate, 0.05-0.15mol/L sodium sulfide (stabilizer), 0.1-1mol/L sodium acetate (buffer), 0.1-1mol/L tartaric acid (complexing agent), and the balance being water. Of course, the aforesaid is only a specific example of the molybdenum chemical plating solution. The molybdenum chemical plating solution may have a different composition. For instance, the molybdenum chemical plating solution may further include other substance such as an accelerator and a pH value regulator, and the concentration of various existing components and selected substances may also be different.

As the process of forming the conductive layer by chemical plating is known, no further description will be given here.

Of course, it should be understood that the step of forming the source conductive layer 31 and the drain conductive layer 41 by the chemical plating process must be carried out after the step of forming the gate insulating layer 21 and before the step of forming the protection layer 5. That is to say, the steps S03 and S04 are exchangeable, namely the conductive layers 31 and 41 may be formed at first and hence the gate electrode 2 is formed. In this case, the metal layer 22 cannot be formed on the gate electrode 2.

For instance, the patterns of the source conductive layer 31 and the drain conductive layer 41 may also be formed by patterning process.

Although the patterning process is relatively complex, the patterning process has a wide application scope and can be used for forming the conductive layers 31 and 41 made of various materials (for instance, the conductive layers made of nonmetal materials can be formed by the patterning process), and forming the conductive layers 31 and 41 of any type, for instance, the conductive layers 31 and 41 each only covering one portion of the surface of the semiconductor layer 1 as illustrated in FIG. 7 may be formed by the patterning process, but the structure can be difficultly formed by the chemical plating process.

Of course, it should be understood that if the source conductive layer 31 and the drain conductive layer 41 are formed by the patterning process, the step can be carried out after the step of forming the semiconductor layer 1 and before the step of forming the protection layer 5, namely the step may be exchanged with the step of forming the gate electrode 2 and the gate insulating layer 21.

S05: for instance, forming the protection layer 5, and forming through holes in the protection layer 5 by a patterning process.

S06: forming patterns of the source electrode 3 and the drain electrode 4 by a patterning process, in which the source electrode 3 and the drain electrode 4 are respectively connected with the source conductive layer 31 and the drain conductive layer 41 via the through holes in the protection layer 5.

Of course, the TFT may be formed by various specific preparation methods based on different structures of the TFT. No further description will be given here. However, as long as the method comprises the step of forming the source conductive layer 31 and the drain conductive layer 41, the method should fall within the scope of protection of the present invention.

### Embodiment 3

The embodiment provides an array substrate, which comprises the aforesaid TFT.

For instance, the array substrate may comprise a substrate and gate lines and data lines formed on the substrate. The gate lines and the data lines are intercrossed to define a plurality of pixel units; each pixel unit is provided with at least one TFT; and at least one TFT adopts the aforesaid TFT.

The array substrate may further comprise other known structures such as a storage capacitor, a pixel electrode, an organic light-emitting diode (OLED), a pixel define layer (PDL). No further description will be given here.

As the array substrate of the embodiment comprises the aforesaid TFT, the array substrate has stable performances and can be used for achieving high-quality display.

### Embodiment 4

The embodiment provides a display device, which comprises the aforesaid array substrate.

For instance, the display device is a liquid crystal display (LCD) device or an OLED display device.

For instance, where the display device is an LCD device, the array substrate and an opposing substrate are arranged opposite to each other to form a liquid crystal cell which is filled with a liquid crystal material therein. The opposing substrate is, for instance, a color filter substrate.

For instance, the display device may further comprise other known structures such as a power supply unit, a frame, a drive unit, a color filter and a liquid crystal layer. No further description will be given here.

As the display device comprises the aforesaid array substrate, the display device has high and stable display quality.

The aforesaid is only the preferred embodiments of the present invention and not intended to limit the scope of protection of the present invention. The scope of protection of the present invention should be defined by the appended claims.

## Claims

1. A method for preparing a thin-film transistor (TFT), the TFT comprising a source electrode (3), a drain electrode (4), a semiconductor layer (1), a gate electrode (2), a gate insulating layer (21) and a source conductive layer (31) and a drain conductive layer (41) disposed on an upper surface of the semiconductor layer (1) and spaced from each other, the source conductive layer (31) connected with the source electrode (3), the drain conductive layer (41) connected with the drain electrode (4), a minimum distance between the source conductive layer (31) and the drain conductive layer (41) being less than a minimum distance between the source electrode (3) and the drain electrode (4), the method comprising:
forming a pattern of the semiconductor layer (1) by a first patterning process;
forming patterns of the gate insulating layer (21) disposed on the semiconductor layer (1) and the gate electrode (2) disposed on the gate insulating layer (21) by a second patterning process;
forming patterns of the source conductive layer (31) and the drain conductive layer (41);
forming a protection layer (5) covering the semiconductor layer (1), the source conductive layer (31), the drain conductive layer (41), the gate electrode (2) and the gate insulating layer (21), and forming through holes in the protection layer (5) by a third patterning process; and
forming patterns of the source electrode (3) and the drain electrode (4) by a fourth patterning process, in which the source electrode (3) and the drain electrode (4) are respectively connected with the source conductive layer (31) and the drain conductive layer (41) via the through holes in the protection layer (5); wherein
a portion on the upper surface of the semiconductor layer (1), not covered by the gate insulating layer (21), is divided into a source region and a drain region, which are independent of each other, by the gate insulating layer (21); and the source region and the drain region are respectively covered by the source conductive layer (31) and the drain conductive layer (41); wherein the semiconductor layer (1) is a metal oxide semiconductor layer; **characterized in that**
forming of the source conductive layer (31) and the drain conductive layer (41) in the source region and the drain region on the upper surface of the semiconductor layer (1) respectively is conducted by a chemical plating process, and a metal layer (22) is simultaneously formed on the gate electrode (2) by the chemical plating process.

2. The method for preparing the TFT according to claim 1, wherein the source conductive layer (31) and the drain conductive layer (41) are made of at least one metal selected from the group consisting of molybdenum, copper, aluminum and tungsten.

3. The method for preparing the TFT according to claim 1, wherein at least one of the source conductive layer (31) and the drain conductive layer (41) is composed of at least two mutually overlapped sub-source/ drain conductive layers.

## Patentansprüche

1. Verfahren zur Herstellung eines Dünnschichttransistors (TFT), wobei der TFT eine Source-Elektrode (3), eine Drain-Elektrode (4), eine Halbleiterschicht (1), eine Gate-Elektrode (2), eine Gate-Isolierschicht (21) und eine Source-Leitschicht (31) und eine Drain-Leitschicht (41), die auf einer oberen Oberfläche der Halbleiterschicht (1) und voneinander beabstandet angeordnet sind umfasst, wobei die Source-Leitschicht (31) mit der Source-Elektrode (3) verbunden ist, wobei die Drain-Leitschicht (41) mit der Drain-Elektrode (4) verbunden ist, wobei ein minimaler Abstand zwischen der Source-Leitschicht (31) und der Drain-Leitschicht (41) kleiner ist als ein minimaler Abstand zwischen der
Source-Elektrode (3) und der Drain-Elektrode (4), wobei das Verfahren umfasst:
Bilden eines Musters auf der Halbleiterschicht (1) mittels eines ersten Bemusterungsprozesses; Bilden von Mustern auf der Gate-Isolierschicht (21), die auf der Halbleiterschicht (1) angeordnet ist, und der Gate-Elektrode (2), die auf der Gate-Isolierschicht (21) angeordnet ist, mittels eines zweiten Bemusterungsprozesses;
Bilden von Mustern auf der Source-Leitschicht (31) und der Drain-Leitschicht (41);
Bilden einer Schutzschicht (5), welche die Halbleiterschicht (1), die Source-Leitschicht (31), die Drain-Leitschicht (41), die Gate-Elektrode (2) und die Gate-Isolierschicht (21) bedeckt, und Bilden von Durchgangsöffnungen in der Schutzschicht (5) mittels eines dritten Bemusterungsprozesses; und
Bilden von Mustern der Source-Elektrode (3) und der Drain-Elektrode (4) mittels eines vierten Bemusterungsprozesses, wobei die Source-Elektrode (3) bzw. die Drain-Elektrode (4) mit der Source-Leitschicht (31) und der Drain-Leitschicht (41) mittels der Durchgangsöffnungen in der Schutzschicht (5) verbunden werden; wobei
ein Bereich auf der oberen Oberfläche der Halbleiterschicht (1), der nicht mittels der Gate-Isolierschicht (21) bedeckt ist, mittels der Gate-Isolierschicht (21) unterteilt ist in eine Source-Region und eine Drain-Region, die voneinander unabhängig sind; und wobei die Source-Region bzw. die Drain-Region mittels der Source-Leitschicht (31) und der Drain-Leitschicht (41) bedeckt sind; wobei die Halbleiterschicht (1) eine Metalloxid-Halbleiterschicht ist;
**dadurch gekennzeichnet,**
**dass** das Bilden der Source-Leitschicht (31) und der Drain-Leitschicht (41) in der Source-Region und der Drain-Region auf der oberen Oberfläche der Halbleiterschicht (1) jeweils mittels eines chemischen Plattierungsprozesses durchgeführt wird und dass mittels des chemischen Plattierungsprozesses auf der Gate-Elektrode (2) gleichzeitig eine Metallschicht (22) gebildet wird.

2. Verfahren zur Herstellung des TFTs gemäß Anspruch 1, wobei die Source-Leitschicht (31) und die Drain-Leitschicht (41) aus zumindest einem Metall hergestellt sind, dass aus der Gruppe, die aus Molybdän, Kupfer, Aluminium und Wolfram besteht, gewählt ist.

3. Verfahren zur Herstellung des TFTs gemäß Anspruch 1, wobei zumindest eine von der Source-Leitschicht (31) und der Drain-Leitschicht (41) aus zumindest zwei sich gegenseitig überlappenden Sub-Source-/Drain-Leitschichten zusammengesetzt ist.

## Revendications

1. Un procédé de préparation d'un transistor à couche mince (TFT), le TFT comprenant une électrode de source (3), une électrode de drain (4), une couche semi-conductrice (1), une électrode de grille (2), une couche isolante de grille (21) et une couche conductrice de source (31) et une couche conductrice de drain (41) disposées sur une surface supérieure de la couche semi-conductrice (1), à distance l'une de l'autre, la couche conductrice de source (31) étant reliée à l'électrode de source (3), la couche conductrice de drain (41) étant reliée à l'électrode de drain (4), une distance minimale entre la couche conductrice de source (31) et la couche conductrice de drain (41) étant inférieure à une distance minimale entre l'électrode de source (3) et l'électrode de drain (4), le procédé comprenant :
formation d'un motif de la couche semi-conductrice (1) par un premier processus de formation de motif ;
formation de motifs de la couche isolante de grille (21) disposée sur la couche semi-conductrice (1) et l'électrode de grille (2) disposée sur la couche isolante de grille (21) par un deuxième processus de formation de motifs ;
formation de motifs de la couche conductrice de source (31) et de la couche conductrice de drain (41) ;
formation d'une couche de protection (5) recouvrant la couche semi-conductrice (1), la couche conductrice de source (31), la couche conductrice de drain (41), l'électrode de grille (2) et la couche isolante de grille (21), et formation de trous traversants dans la couche de protection (5) par un troisième processus de formation de motifs ; et
formation de motifs de l'électrode de source (3) et de l'électrode de drain (4) par un quatrième processus de formation de motifs, dans lequel l'électrode de source (3) et l'électrode de drain (4) sont respectivement reliées à la couche conductrice de source (31) et à la couche conductrice drain (41) via les trous traversants dans la couche de protection (5) ; dans lequel
une partie de la surface supérieure de la couche semi-conductrice (1), non recouverte par la couche isolante de grille (21), est divisée en une région de source et une région de drain, qui sont indépendantes l'une de l'autre, par la couche isolante de grille (21) ; et la région de source et la région de drain sont respectivement couvertes par la couche conductrice de source (31) et la couche conductrice de drain (41) ; dans lequel la couche semi-conductrice (1) est une couche semi-conductrice d'oxyde métallique ;
**caractérisé en ce que**
la formation de la couche conductrice de source (31) et de la couche conductrice de drain (41) dans la région de source et la région de drain sur la surface supérieure de la couche semi-conductrice (1) respectivement est effectuée par un processus de placage chimique, et une couche métallique (22) est formée simultanément sur l'électrode de grille (2) par le processus de placage chimique.

2. Le procédé de préparation du TFT selon la revendication 1, dans lequel la couche conductrice de source (31) et la couche conductrice de drain (41) sont faits d'au moins un métal choisi dans le groupe constitué par le molybdène, le cuivre, l'aluminium et le tungstène.

3. Le procédé de préparation du TFT selon la revendication 1, dans lequel au moins l'une de la couche conductrice de source (31) et de la couche conductrice de drain (41) est composée d'au moins deux couches conductrices de sous-source/ drain se chevauchant mutuellement.
